# EUROPÄISCHE PATENTSCHRIFT

(11) **EP 0 586 793 B1**
(45) Veröffentlichungstag und Bekanntmachung des Hinweises auf die Patenterteilung: **07.02.1996**
(21) Anmeldenummer: 93108420.6
(22) Anmeldetag: 25.05.1993
(51) Int. Cl.: H02M 7/00, H02M 7/538

(54) **Halbbrückenanordnung**
Half-bridge configuration
Configuration en demi-pont

(30) Priorität: 11.09.1992 DE 4230510
(43) Veröffentlichungstag der Anmeldung: 16.03.1994
(73) Patentinhaber: GRÜNDL UND HOFFMANN GmbH GESELLSCHAFT FÜR ELEKTROTECHNISCHE ENTWICKLUNGEN, D-82319 Starnberg (DE)
(72) Erfinder: Gründl, Andreas, Dr. Phys., W-8000 München 70 (DE); Hoffmann, Bernhard, Dipl.-Ing., W-8130 Starnberg (DE)
(74) Vertreter: Schmidt, Steffen J., Dipl.-Ing.

(56) Entgegenhaltungen:
- EP-A- 0 443 378
- DE-U- 9 213 612
- US-A- 5 132 896

## Beschreibung

Die Erfindung betrifft eine Halbbrückenanordnung zum Schalten elektrischer Leistungen, bei der wenigstens zwei Halbleiterschalter unter Bildung einer Halbbrücke in Serie geschaltet sind; jeder Halbleiterschalter einen Steuereingang aufweist, der mit einer Ansteuereinrichtung verbunden ist; jeder erste Halbleiterschalter mit seinem Source-Anschluß auf einem hohen Spannungspotential liegt; jeder zweite Halbleiterschalter mit seinem Drain-Anschluß auf einem niedrigen Spannungspotential liegt; zur Bildung eines Ausgangsanschlusses der Drain-Anschluß jedes ersten Halbleiterschalters mit dem Source-Anschluß jedes jeweiligen zweiten Halbleiterschalters verbunden ist; wenigstens eine Kondensatoranordnung zwischen dem hohen und dem niedrigen Spannungspotential angeordnet ist; und die Ansteuereinrichtung die Halbleiterschalter mit einem Steuersignal von mehr als 20 kHz Schaltfrequenz ansteuert.

Derartige Halbbrückenanordnungen sind zur Bildung von Wechselrichtern für die unterschiedlichsten Anwendungsbereiche, z.B. zur Speisung von Drehfeldmaschinen, Permanentmagnetmotoren und dergl. im Einsatz (siehe z.B. DE-A-40 27 969).

Allerdings besteht hier das Problem, daß die Leistungsdichte, d.h. die abgegebene Leistung bezogen auf das Volumen der Anordnung bei den herkömmlichen Anordnungen relativ gering ist. Außerdem ist das Gewicht der herkömmlichen Anordnungen relativ hoch.

Aus der EP 0 443 378 A2 ist ein elektronischer Leistungsschalter in Halbbrückenschaltung bekannt, der zwischen zwei Gleichspannungsanschlüssen eine Reihenschaltung von zwei Ventilgruppen aus einer Parallelschaltung von mehreren gleichartigen Ventilen geringer Strombelastbarkeit besteht. Alle Ventile beider Gruppen sind auf einer gemeinsamen Leiterplatte befestigt. Mindestens ein Stützkondensator ist auf derselben Leiterplatte befestigt und die Ventile werden im Schaltbetrieb eingesetzt. Der Aufbau der Leiterplatte mit Kühlschienen und den Ventilen ergibt einen Leistungsschalter mit deutlich reduzierten Streuinduktivitäten.

Aus der US-PS 5,132,896 ist eine Wechselrichteranordnung bekannt, die zur Verringerung der Wirkung verteilter Induktivitäten der Leiter, die zum Verbinden der Kondensatoren und der Halbleiterschalter verwendet werden, plattenförmige Zuleitungen mit großer Fläche aufweist. Dadurch werden große Dämpfungskondensatoren zur Kompensation der Leitungsinduktivitäten vermieden. Außerdem kann durch die großflächige Gestaltung der plattenförmigen Zuleitungen die Wärmeabstrahlung verbessert werden. Des weiteren sind die plattenförmigen Zuleitungen so gestaltet, daß die Größe und die Richtung des Stromflusses durch die plattenförmigen Zuleitungen die Wirkung der verteilten Induktivitäten minimieren.

Allerdings dienen bei dieser Wechselrichteranordnung die größflächigen Zuleitungen lediglich der Minderung von Störinduktivitäten und sind als Zuleitungen zu großen Elektrolytkondensatoren eingesetzt.

Um diese Nachteile zu überwinden, ist die eingangs beschriebene Halbbrückenanordnung dahin gehend weitergebildet, daß die Kondensatoranordung durch wenigstens einen Flächenkondensator an einer die Halbleiterschaltertragenden Platine und/oder durch wenigstens einen als Hohlwickel geformten Wickelkondensator gebildet ist; wobei die Halbleiterschalter in dem als Hohlwickel gebildeten Wickelkondensator angeordnet sind; und eine Fluidkühlung in dem Hohlwickel vorgesehen ist.

Durch eine hohe Schaltfrequenz ist es möglich, mit kleineren Kapazitäten in der Kondensatoranordnung auszukommen, als dies bei herkömmlichen Halbbrücken der Fall ist. Bei der erfindungsgemäßen Anordnung nimmt die Kondensatoranordnung etwa 3% des Volumens ein, das bei herkommlichen Halbbrückenanordnungen erforderlich ist. Angesichts der Tatsache, daß die Kondensatoren bei herkommlichen Halbbrückenanordnungen etwa 40% des Gesamtvolumens ausmachen, ist dies eine erhebliche Verringerung des Volumens. Außerdem sind bei herkommlichen Halbbrückenanordnungen die Kondensatoren als Elektrolytkondensatoren ausgebildet, was einerseits zur Verringerung der Lebensdauer und andererseits dazu führt, daß die ein Einsatz im Ex-Bereich nicht möglich ist.

Außerdem erlaubt die hohe Schaltfrequenz - vorzugsweise beträgt die Schaltfrequenz bis zu 100 kHz - eine präzisere Wahl des Kurvenverlaufs des entnommenen Stroms, so daß der Filteraufwand reduziert werden kann.

Da bei den hohen Schaltfrequenzen die Ausbildung der Zuleitungen auf den Platinen und in der der Umhüllung als kapazitätsbehaftete Bauteile ausreicht um die erforderlichen Kapazitätswerte für die Stützkondensatoren zu erzielen, sind die erforderlichen Kapazitäten sehr dicht an die Halbleiterschalter heranführbar, so daß ein optimaler Aufbau gewährleistet ist.

Weiterhin entfallen durch den kompakten Aufbau in dem einen Teil der Kondensatoranordnung bildenden Hohlwickel bzw. an der Platine, die Probleme im Zusammenhang mit Überspannungen beim Schaltvorgang weitgehend. Damit ist es möglich, die Bauteile bis an die Grenze ihrer Spannungsfestigkeit zu betreiben.

Durch die Ausbildung der Umhüllung als Teil der Kondensatoranordnung, die die schaltenden Baulelemente umgibt, ist sowohl die Abstrahlung von Streufeldern minimiert, als auch die Einstrahlstörsicherheit maximiert.

Durch das verringerte Volumen ist es möglich, eine große Anzahl kleinbauender Halbleiterschalter zu verwenden, so daß die Kühlung der einzelnen Halbleiterschalter wegen der größeren Verteilung einfacher zu bewerkstelligen ist, als bei wenigen großbauenden Bauteilen.

Außerdem gestattet die Verwendung vieler kleiner Bauelemente ein asynchrones Schalten, wodurch eine bessere Ausnutzung der vorhandenen Kapazitäten ermöglicht ist.

Wegen der hohen Schaltfrequenzen ist es möglich, die leitungsgebundenen Störungen leichter herauszufiltern, so daß die Störschutzmaßnahmen weniger aufwendig sind, als beim Stand der Technik.

Vorteilhafte Weiterbildungen des Erfindungsgegenstandes sind Gegenstand von weiteren Ansprüchen.

Da der kompakte Aufbau eine hohe Leistungsdichte und entsprechende Maßnahmen zur Kühlung erfordert, ist die gewählte Fluidkühlung einerseits zwar erforderlich, läßt aber andererseits auch die hermetische bzw. fluiddichte Kapselung der Anordnung zu, was selbst die höchsten Sicherheitsanforderungen erfüllt. In diesem Zusammenhang ist zu bemerken, daß ein kleines Volumen besser zu kapseln ist als ein großes Volumen, wie es bei Anordnungen nach dem Stand der Technik der Fall ist.

Bei einer bevorzugten Ausführungsform sind die Halbleiterschalter durch schnellschaltende, verlustarme Feldeffekt-Transistoren (FETs) oder durch schnellschaltende, verlustarme bipolare Transistoren mit isoliertem Gateanschluß (IGBTs) gebildet. Dabei können insbesondere MOS-FETs mit integrierten Freilaufdioden oder mit (zusätzlichen) externen Freilaufdioden eingesetzt werden.

Zum einen sind diese Bauelemente ohne weiteres parallel schaltbar, um die jeweils gewünschten Belastbarkeiten hinsichtlich des Schaltstromes zu erzielen, und zum anderen ist die Ansteuerleistung gering, so daß die Ansteuerelektronik keine aufwendige Endstufen benötigt.

Durch die Verwendung vieler Halbleiterschalterelemente mit jeweils einer kleinen Schaltleistung, die jedoch einfach parallelschaltbar sind, kann eine gute Kühlung erreicht werden, da die vielen Einzelbauteile gut durch das Kühlmedium erreichbar sind.

Um eine einfach kaskadierbare Modulbauweise zu ermöglichen, und für einen besonders kompakten Aufbau ist es vorteilhaft, wenn auch die Ansteuereinrichtung im Innern des Hohlwickels angeordnet ist.

Um einen möglichst induktivitätsarmen und kapazitiven Aufbau der Zuleitungen und der Verdrahtung zu haben, und um eine möglichst hohe Kapazität in der Platinenanordnung unterzubringen, ist bei einer bevorzugten Ausführungsform die Platine als mehrlagige Platine ausgebildet, wobei zumindest eine erste leitende Schicht das hohe Spannungspotential führt; eine zweite leitende Schicht das niedrige Spannungspotential führt; und zwischen der ersten und der zweiten leitenden Schicht eine Isolierschicht angeordnet ist.

Damit stellt praktisch die gesamte Stromzuführung einen Kondensator dar, wobei durch geeignete Wahl hinsichtlich Spannungsfestigkeit und Dielektrizitätskonstante der Isolierschicht, die Kenngrößen der Kapazität für eine vorbestimmte Fläche der Platine festlegbar sind.

Um ggf. eine hohe Kapazität der als Stützkondensator wirkenden Kondensatoranordnung zu erzielen, ist zusätzlich der Hohlwickel mehrschichtig ausgebildet, wobei zumindest eine erste leitende Schicht das hohe Spannungspotential führt; zumindest eine zweite leitende Schicht das niedrige Spannungspotential führt; und zwischen der ersten und der zweiten leitenden Schicht eine Isolierschicht angeordnet ist. Hierbei gilt hinsichtlich der Kapazität das gleiche wie für die Platine. Allerdings kann durch einfaches Mehrfachwickeln der einzelnan Lagen die Kapazität fast beliebig erhöht werden.

Um bei Halbbrückenanordnungen für Mehrphasenbetrieb, oder bei mehreren parallel geschalteten Anordnungen die Baugruppen auf den einzelnen Platinen voneinander hinreichend zu entkoppeln, ist es vorteilhaft, wenn der Hohlwickel mehrere Anordnungen bestehend aus ersten und zweiten Lagen, sowie Isolierschichten aufweist, wobei die einzelnen Anordnungen an der Innenseite des Hohlwickels in Umfangsrichtung so versetzt auslaufen, daß Bereiche der einzelnen ersten und zweiten leitenden Schichten sowie isolierte Anschlußstreifen freiliegen.

Auf diese Weise können einzelne gleich aufgebaute Platinen über einander gestapelt in den Hohlwickel eingeschoben werden, und durch jeweils geringfüg verdrehte Anschlußstellen an den Platinen mit den jeweiligen isolierten Leiterstreifen an der Innenseite des Hohlwickels in Kontakt kommen.

Um Spannungsdurchschläge zwischen den einzelnen Kondensatoranordnungen zu vermeiden, und auch um die einzelnen Kondensatoren voneinander besser zu entkoppeln, sind bevorzugt die einzelnen Anordnungen bestehend aus den ersten und zweiten Lagen sowie aus der Isolierschicht so übereinander geschichtet, daß jeweils die erste bzw. zweite leitende Schicht einer Anordnung der ersten bzw. zweiten leitenden Schicht einer einer weiteren Anordnung benachbart ist, und zwischen den einzelnen Anordnungen eine dünne Isolierlage angeordnet ist. Damit ist keine Potentialdifferenz zwischen den einzelnen Anordnungen vorhanden, so daß nur geringe Anforderungen an die Isolierlage zu stellen sind.

Bevorzugt ist die erste leitende Schicht eine Kupferschicht mit wenigstens 35µm - 70 µm Dicke; die zweite leitende Schicht eine Kupferschicht mit wenigstens 35µm - 70 µm Dicke; und die Isolierschicht eine Kunststoffschicht mit wenigstens 10 - 20 µm Dicke aus Kapton. Abhängig von der geforderten Kapazität und Spannungsfestigkeit sind jedoch auch andere Abmessungen oder Materialien möglich.

Um Vollbrückenanordnungen oder andere Schaltungen zu realisieren, oder um Halbbrückenanordnungen mit besonders hoher Schaltleistung bereitzustellen, sind mit Vorteil im Innern des Hohlwickels mehrere Platinen mit Halbbrücken in axialem Abstand angeordnet sind, bei denen Anschlüsse der einzelnen Platinen für das hohe und das niedrige Spannungspotential bzw. für die jeweilige Kondensatoranordnung, bzw. für Steueranschlüsse und Ausgangsanschlüsse am Umfang der einzelnen Platinen so angeordnet sind, daß sie die freiliegenden Bereiche der einzelnen ersten und zweiten leitenden Schichten bzw. isolierte Leiterstreifen kontaktieren.

Dieser Aufbau erlaubt eine Modularisierung der einzelnen Platinen, und lediglich die Verschaltung außerhalb des Hohlwickels bestimmt die Schaltleistung bzw. die Schaltung als Ganzes.

Um Sicherheitsanforderungen gerecht zu werden, die z. B. in der Bergwerkstechnik oder in anderen gefährdeten Bereichen herrschen, ist es vorteilhaft, wenn der Hohlwickel eine Ummantelung aufweist, so daß die Gesamtanordnung bis etwa 15 bar druckfest ausgebildet ist. Damit kann ein im Innern des Hohlwickels auftretender Schaden nicht nach außen dringen.

Dies gilt insbesondere, wenn die Flüssigkeitskühlung als Siedebadkühlung mit einem flüssigen Fluorkohlenwasserstoff ausgebildet ist, wobei der Druck im Innern des Hohlwickels zwischen 50 mbar und 3 bar, und die Temperaturdifferenz zwischen den Halbleiterschaltern und der den Hohlwickel umgebenden Atmosphäre etwa 10°C beträgt. In diesem Zusammenhang wirkt der flüssige Fluorkohlenwasserstoff, welcher die Halbleiterschalter umspült, auch als Abdichtung der Halbleiter gegenüber der Umgebungsatmosphäre, was zur Folge hat, daß herkömmliche Bauteile, die lediglich kunststoffummantelt sind, eine Lebensdauer haben, die mit der von hermetisch dichten MIL-Bauteilen vergleichbar ist.

Obwohl Fluorkohlenwasserstoffe als Kühlmittel relativ umweltverträglich sind, ist ihr Einsatz aufgrund des hohen Preises bisher kaum üblich. Da bei der kompakten Anordnung gemäß der Erfindung lediglich kleine Mengen erforderlich sind, spielt der Preis des Fluorkohlenwasserstoff keine so große Rolle.

Durch die druckfeste Abdichtung des Hohlwickels kann die Siedekühlung entlang der Dampfdruckkurve des Fluorkohlenwasserstoffs erfolgen. Dies hat zur Folge, daß bereits geringfügige Temperatursteigerungen an den Halbleiterschaltern das Einsetzen der Kühlung bewirken.

Damit die Halbleiterschalter bei möglichst niedriger Temperatur gehalten werden, weist die Siedebadkühlung einen Rückkühlwärmetauscher auf, der über an der Außenfläche des Hohlwickels angeordnete Konvektionskühleinrichtungen Verlustwärme aus dem Innern des Hohlwickels abführt.

In der Zeichnung ist eine bevorzugte Ausführungsform des Erfindungsgegensandes veranschaulicht. Es zeigen:
- Fig. 1: einen elektrischen Schaltplan eines einphasigen Wechselrichters mit zwei Halbbrückenanordnungen;
- Fig. 2a: eine Platine, die die Halbbrückenanordnungen trägt, in einer teilweisen schematischen Querschnittsdarstellung;
- Fig. 2b: einen Hohlwickel in einer längsgeschnittenen schematischen Teilansicht; und
- Fig. 3: eine Halbbrückenanordnung mit mehreren Platinen in einem Hohlwickel in einem schematischen Längsschnitt;

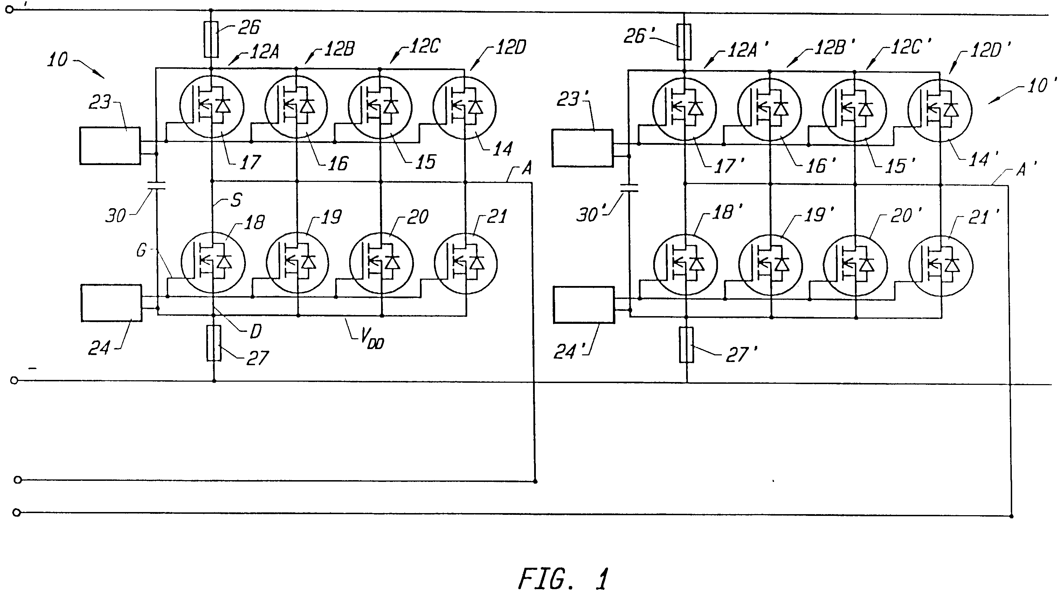

Fig. 1 zeigt als ein Anwendungsbeispiel für die erfindungsgemäße Halbbrückenanordnung einen einphasigen Wechselrichter mit zwei Halbbrückenanordnungen 10, 10', deren Aufbau identisch ist. Daher wird im folgenden nur eine der beiden Halbbrückenanordnungen im Detail erläutert, wobei die andere andere Halbbrückenanordnung mit gleichen Bezugszeichen mit Apostroph bezeichnet ist.

Die Halbbrückenanordnung 10 weist vier parallel geschaltete Paare 12a, 12 b, 12c, 12d von N-Kanal MOSFETs auf, die als Halbleiterschalter wirken. Jeweils zwei der N-Kanal MOSFETs 14, 21; 15, 20; 16, 19; 17, 18, die jeweils ein Paar bilden, in Serie geschaltet, so daß jeweils der erste N-Kanal MOSFET 14; 15; 16; 17 jedes Paares mit seinem Source-Anschluß auf einem hohen Spannungspotential V_{SS} liegt, und jeder zweite N-Kanal MOSFET 21; 20; 19; 18 jedes Paares mit seinem Drain-Anschluß auf einem niedrigen Spannungspotential V_{DD} liegt. Dabei ist zur Bildung eines Ausgangsanschlusses A der Drain-Anschluß jedes der ersten N-Kanal MOSFETs 14; 15; 16; 17 mit dem Source-Anschluß jedes der zweiten N-Kanal MOSFETs 21; 20; 19; 18 verbunden. Jeweils eine Ansteuereinrichtung 23, 24 für die Gruppe der ersten N-Kanal MOSFETs 14; 15; 16; 17 bzw. der Gruppe der zweiten N-Kanal MOSFETs 21; 20; 19; 18 ist mit den parallel geschalteten Steuereingängen jeder Gruppe der ersten und zweiten N-Kanal MOSFETs verbunden. Die Zuführungen des hohen und des nierigen Spannungspotentials (V_{SS} und V_{DD}) zu den Source- bzw. Drainanschlüssen der N-Kanal MOSFETs sind jeweils durch eine Sicherung 26, 27 abgesichert.

Zwischen dem hohen und dem niedrigen Spannungspotential V_{SS} und V_{DD} ist ein Kondensator 30 angeordnet, der als Stützkondensator wirkt. Die konkrete Ausführung des Kondensators 30 ist weiter unten beschrieben. Jede Ansteuereinrichtung 23, 34 steuert die jeweiligen Gruppe der N-Kanal MOSFETs mit einem Steuersignal von mehr als 20 kHz Schaltfrequenz an. Vorzugsweise beträgt die Schaltfrequenz bis zu 100 kHz.

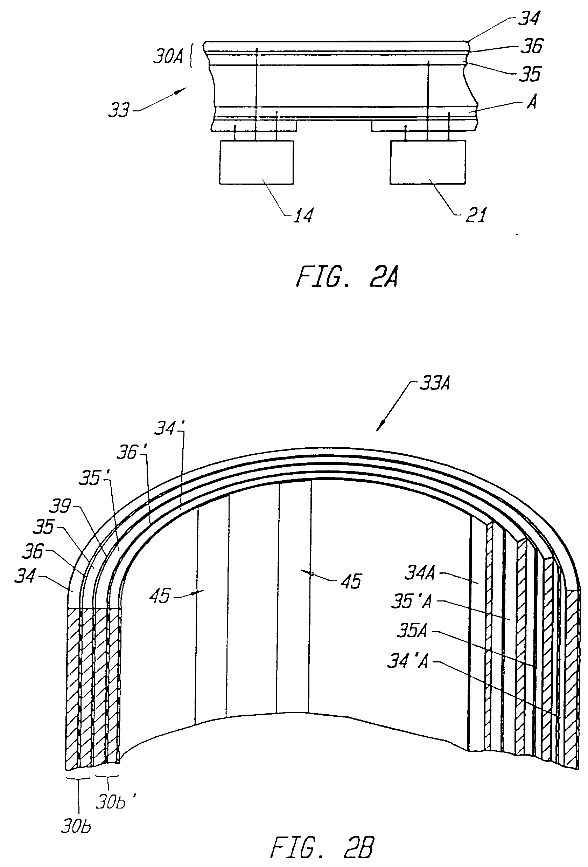

Wie in den Fig. 2a veranschaulicht, ist die Kondensatoranordung 30 zum einen durch wenigstens einen Flächenkondensator 30a an einer die MOSFETs tragenden Platine 33 gebildet. Dabei sind zwei 70 µm dicke Kupferschichten 34, 35 durch eine 10 µm - 20 µm dicke Isolierschicht 36 aus Kapton voneinander getrennt. Die Kupferschichten 34, 35 liegen auf hohem bzw. niedrigem Spannungspotential V_{SS} und V_{DD}.

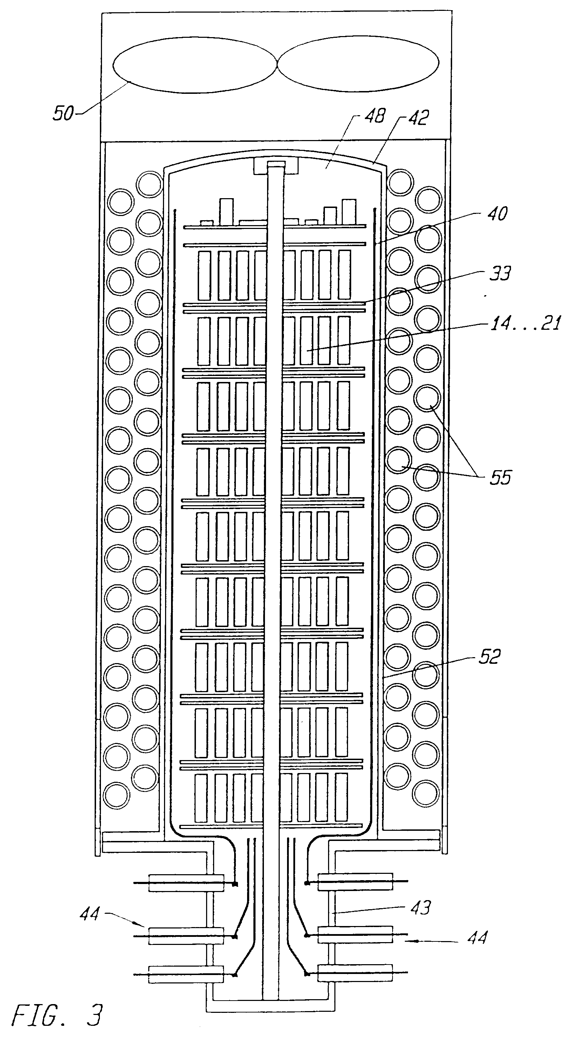

Zum anderen ist, wie in Fig. 2b und in Fig. 3 veranschaulicht, die Kondensatoranordnung 30 durch einen als Hohlwickel 40 geformten Wickelkondensator 30b gebildet. Wegen einer besseren Anschaulichkeit ist für jede Kondensatoranordnung 30b nur eine Lage gezeigt, und insgesamt sind nur zwei Lagen veranschaulicht. Allerdings sind tatsächlich für jede Kondensatoranordnung mehrere Lagen vorgesehen, und zu jeder Platine ist eine separate Kondensatoranordnung 30b zugeordnet.

Der Hohlwickel 40 ist im wesentlichen zylinderförmig gestaltet und besteht aus mehreren Lagen von Kupferschichten 34, 35 und jeweils einer Isolierschicht 36. Zur Erhöhung der Durchschlagsicherheit zwischen den einzelnen Kondensatoranordnungen und zur besseren Entkopplung sind dabei die einzelnen Anordnungen bestehend aus den Kupferschichten 34, 35 und jeweils einer Isolierschicht 36 so übereinander geschichtet, daß jeweils die erste bzw. zweite Kupferschicht 34, 35 einer Anordnung der ersten bzw. zweiten Kupferschicht 34', 35' einer weiteren Anordnung 34', 35', 36' benachbart ist. Zwischen den einzelnen Anordnungen 34, 35, 36; 34', 35', 36' ist eine dünne Isolierlage 39 angeordnet. Mit anderen Worten sind jeweils aneinander angrenzende Kondensatoranordnungen 30b, 30b' gegensinnig aneinanderliegend angeordnet.

Im Innern des als Hohlwickel 40 ausgebildeten Wickelkondensator 30b sind mehrere Platinen 33 mit einzelnen Halbleiteranordnungen übereinandergeschichtet.

Der Hohlwickel 40 ist an einem Ende fluiddicht mit einer konvexen Abdeckkappe 42 verschlossen, während er sich am anderen Ende flaschenförmig verjüngt, um in einem Ansatzstutzen 43 auszulaufen, an dem die Anschlüsse 44 für die Versorgungsspannungen, die Ausgangsleitungen, und die Steuerleitungen nach außen treten.

Um für jede der übereinandergeschichteten Platinen 33 eine separaten Kondensator 30b, einen separaten Ausgangsanschluß A, sowie entsprechende Steueranschlüsse bereitstellen zu können, die auf einfache Weise mit den Anschlüssen 44 verbunden werden können, ist der Aufbau des Hohlwickels 40 derart getroffen, daß die einzelnen Kupferschichten an der Innenseite des Hohlwickels 40 in Umfangsrichtung so versetzt auslaufen, daß Bereiche 34a, 35a, 34'a, 35'a der einzelnen ersten und zweiten Kupferschichten 34, 35, 34', 35', sowie isolierte Leiterstreifen 45 für die Ausgangsanschlüsse A freiliegen.

Entlang des Umfangs der kreisscheibenförmigen Platinen 33, deren Außendurchmesser dem Innendurchmesser des Hohlwickels 40 etwa entspricht, sind die Anschlüsse für das hohe und das niedrige Spannungspotential, für die jeweilige Kondensatoranordnung, bzw. für Steueranschlüsse und Ausgangsanschlüsse so angeordnet, daß sie die freiliegenden Bereiche 34a, 35a, 34'a, 35'a der einzelnen ersten und zweiten Kupferschichten, bzw. die isolierten Leiterstreifen 45 kontaktieren.

Der Hohlwickel weist eine Ummantelung 52 auf, so daß die Gesamtanordnung bis etwa 15 bar druckfest ausgebildet ist.

Das Innere des Hohlwickels 40 ist mit einem flüssigen Fluorkohlenwasserstoff gefüllt, wobei die Flüssigkeit die Halbleiterschalter bedeckt. Dabei ist ein freier Raum zwischen dem Flüssigkeitsspiegel und der Abdeckung 42, so daß eine gasförmige Phase des Fluorkohlenwasserstoffs aus der flüssigen Phase austreten kann. Der Gasdruck in dem Hohlwickel 40 ist entsprechend der Gasdruckkurve des Fluorkohlenwasserstoffs zwischen 50 mbar und 3 bar so eingestellt, daß bereits bei geringfügiger Erwärmung der MOSFETs im Betrieb die flüssige Phase der Fluorkohlenwasserstoffs zu sieden beginnt. So ist erreichbar, daß die Temperaturdifferenz zwischen den Halbleiterschaltern und der den Hohlwickel umgebenden Atmosphäre lediglich etwa 10°C beträgt.

Da der Hohlwickel 40 von außen durch Konvektionskühlung oder durch - lediglich schematisch veranschaulichte - Gebläsekühlung 50 gekühlt wird, kondensiert die Gasphase des Fluorkohlenwasserstoffs an der von außen gekühlten Innenwand des Hohlwickels und wird in flüssiger Form über eine - nicht weiter veranschaulichte Pumpeinrichtung wieder dem flüssigen Fluorkohlenwasserstoff zugeführt, der die MOSFETs umgibt. Dieser Aufbau wirkt als Rückkühlwärmetauscher, der über an der Außenfläche des Hohlwickels 40 angeordnete Konvektionskühleinrichtungen 55 Verlustwärme aus dem Innern des Hohlwickels 40 abführt.

In der Fig. 3 ist der Hohlwickel 40 stehend gezeigt, so daß die freie Raum über dem flüssigen Fluorkohlenwasserstoff für die Gasphase relativ gering ist, und auch der Bereich der Innenwand, an dem die Kondensation stattfinden kann, relativ klein ist. Daher kann es günstiger sein, den Hohlwickel liegend anzuordnen, und auch die Platinen entsprechend zu gestalten und zu bestücken, so daß ein Bereich der Zylinderwand frei ist, was bei bestimmten Verhältnissen von Füllhöhe, Länge und Durchmesser des Hohlwickels 40 zu einer größeren Kondensationsfläche führt.

## Patentansprüche

1. Halbbrückenanordnung zum Schalten elektrischer Leistungen, bei der
- wenigstens zwei Halbleiterschalter (14, 21; 15, 20; 16, 19; 17, 18) unter Bildung einer Halbbrücke (12a; 12b; 12c; 12d) in Serie geschaltet sind;
- jeder Halbleiterschalter (14, 21; 15, 20; 16, 19; 17, 18) einen Steuereingang (G) aufweist, der mit einer Ansteuereinrichtung (23, 24) verbunden ist;
- jeder erste Halbleiterschalter (14; 15; 16; 17) mit seinem Source-Anschluß (S) auf einem hohen Spannungspotential (V_{SS}) liegt;
- jeder zweite Halbleiterschalter (18; 19; 20; 21) mit seinem Drain-Anschluß (D) auf einem niedrigen Spannungspotential (V_{DD}) liegt;
- zur Bildung eines Ausgangsanschlusses (A) der Drain-Anschluß (D) jedes ersten Halbleiterschalters (14; 15; 16; 17) mit dem Source-Anschluß (S) jedes jeweiligen zweiten Halbleiterschalters (18; 19; 20; 21) verbunden ist; und
- wenigstens eine Kondensatoranordnung (30) zwischen dem hohen und dem niedrigen Spannungspotential (V_{SS}, V_{DD}) angeordnet ist;
- die Ansteuereinrichtung (23, 24) die Halbleiterschalter (14, 21; 15, 20; 16, 19; 17, 18) mit einem Steuersignal von mehr als 20 kHz Schaltfrequenz ansteuert; dadurch gekennzeichnet, daß
- die Kondensatoranordung (30) durch wenigstens einen Flächenkondensator (30a) an einer die Halbleiterschalter (14, 21; 15, 20; 16, 19; 17, 18) tragenden Platine (33) und/oder durch wenigstens einen als Hohlwickel (40) geformten Wickelkondensator (30b) gebildet ist;
- wobei die Halbleiterschalter (14, 21; 15, 20; 16, 19; 17, 18) in dem als Hohlwickel (40) gebildeten Wickelkondensator (30b) angeordnet sind; und
- eine Fluidkühlung in dem Hohlwickel (40) vorgesehen ist.

2. Halbbrückenanordnung nach Anspruch 1, dadurch gekennzeichnet, daß der Hohlwickel (40) fluiddicht verschlossen ist.

3. Halbbrückenanordnung nach Anspruch 1, dadurch gekennzeichnet, daß die Halbleiterschalter (14, 21; 15, 20; 16, 19; 17, 18) durch schnellschaltende, verlustarme Feldeffekt-Transistoren (FETs) oder durch schnellschaltende, verlustarme bipolare Transistoren mit isoliertem Gateanschluß (IGBTs) gebildet sind.

4. Halbbrückenanordnung nach einem oder mehreren der vorhergehenden Ansprüche, dadurch gekennzeichnet, daß mehrere Paare in Serie geschalteter Halbleiterschalter (14, 21; 15, 20; 16, 19; 17, 18) parallel geschaltet sind.

5. Halbbrückenanordnung nach einem oder mehreren der vorhergehenden Ansprüche, dadurch gekennzeichnet, daß die Halbleiterschalter (14, 21; 15, 20; 16, 19; 17, 18) durch eine große Anzahl von einzelnen Halbleiterschalter-Bauelementen mit jeweils kleinen Schaltleistungen gebildet sind.

6. Halbbrückenanordnung nach einem oder mehreren der vorhergehenden Ansprüche, dadurch gekennzeichnet, daß jede Ansteuereinrichtung (23, 24) im Innern des Hohlwickels (40) angeordnet ist.

7. Halbbrückenanordnung nach einem oder mehreren der vorhergehenden Ansprüche, dadurch gekennzeichnet, daß
- die Platine (33) als mehrlagige Platine ausgebildet ist, wobei zumindest
- eine erste leitende Schicht (34) das hohe Spannungspotential führt;
- eine zweite leitende Schicht (35) das niedrige Spannungspotential führt; und
- zwischen der ersten und der zweiten leitenden Schicht (34, 35) eine Isolierschicht (36) angeordnet ist.

8. Halbbrückenanordnung nach einem oder mehreren der vorhergehenden Ansprüche, dadurch gekennzeichnet, daß
- der Hohlwickel (40) mehrschichtig ausgebildet ist, wobei zumindest eine erste leitende Schicht (34) das hohe Spannungspotential führt;
- zumindest eine zweite leitende Schicht (35) das niedrige Spannungspotential führt; und
- zwischen der ersten und der zweiten leitenden Schicht (34, 35) eine Isolierschicht (36) angeordnet ist.

9. Halbbrückenanordnung nach einem oder mehreren der vorhergehenden Ansprüche, dadurch gekennzeichnet, daß
- der Hohlwickel (40) mehrere Anordnungen bestehend aus ersten und zweiten Lagen (34, 35; 34', 35'), sowie Isolierschichten (36,36') aufweist, wobei
- die einzelnen Anordnungen an der Innenseite des Hohlwickels (40) in Umfangsrichtung so versetzt auslaufen, daß Bereiche (34a, 35a; 34'a, 35'a) der einzelnen ersten und zweiten leitenden Schichten (34, 35; 34', 35',), sowie
- isolierte Leiterstreifen (45) freiliegen.

10. Halbbrückenanordnung nach einem oder mehreren der vorhergehenden Ansprüche, dadurch gekennzeichnet, daß
- die einzelnen Anordnungen bestehend aus den ersten und zweiten Lagen (34, 35; 34', 35') sowie aus der Isolierschicht (36; 36') so übereinander geschichtet sind, daß jeweils die erste bzw. zweite leitende Schicht (35) einer Anordnung der ersten bzw. zweiten leitenden Schicht (35') einer einer weiteren Anordnung benachbart ist, und
- zwischen den einzelnen Anordnungen eine dünne Isolierlage (39) angeordnet ist.

11. Halbbrückenanordnung nach einem oder mehreren der vorhergehenden Ansprüche, dadurch gekennzeichnet, daß
- die erste leitende Schicht (34; 34') eine Kupferschicht mit wenigstens 70 µm Dicke ist;
- die zweite leitende Schicht (35, 35') eine Kupferschicht mit wenigstens 70 µm Dicke ist; und
- die Isolierschicht (36; 36') eine Kunststoffschicht mit wenigstens 10 - 20 µm Dicke aus Kapton ist.

12. Halbbrückenanordnung nach einem oder mehreren der vorhergehenden Ansprüche, dadurch gekennzeichnet, daß
- im Innern des Hohlwickels (40) mehrere Platinen (33) mit Halbbrücken (12; 12') in axialem Abstand angeordnet sind,
- bei denen Anschlüsse der einzelnen Platinen für das hohe und das niedrige Spannungspotential bzw. für die jeweilige Kondensatoranordnung (30), bzw. für Steueranschlüsse und Ausgangsanschlüsse (A) am Umfang der einzelnen Platinen (33) so angeordnet sind, daß sie die freiliegenden Bereiche (34a, 35a; 34'a, 35'a) der einzelnen ersten und zweiten leitenden Schichten (34, 35;34', 35') bzw. isolierte Leiterstreifen (45) kontaktieren.

13. Halbbrückenanordnung nach einem oder mehreren der vorhergehenden Ansprüche, dadurch gekennzeichnet, daß der Hohlwickel (40) eine Ummantelung (52) aufweist, so daß die Gesamtanordnung bis etwa 15 bar druckfest ausgebildet ist.

14. Halbbrückenanordnung nach einem oder mehreren der vorhergehenden Ansprüche, dadurch gekennzeichnet, daß
- die Fluidkühlung als Siedebadkühlung mit einem flüssigen Fluorkohlenwasserstoff ausgebildet ist, wobei der Druck im Innern des Hohlwickels (40) zwischen 50 mbar und 3 bar, und
- die Temperaturdifferenz zwischen den Halbleiterschaltern (14, 21; 15, 20; 16, 19; 17, 18) und der den Hohlwickel (40) umgebenden Atmosphäre etwa 10°C beträgt.

15. Halbbrückenanordnung nach einem oder mehreren der vorhergehenden Ansprüche, dadurch gekennzeichnet, daß
- die Siedebadkühlung einen Rückkühlwärmetauscher aufweist, der über
- an der Außenfläche des Hohlwickels (40) angeordnete Konvektionskühleinrichtungen (50) Verlustwärme aus dem Innern des Hohlwickels (40) abführt.

## Claims

1. A half-bridge arrangement for switching electrical power, wherein
- at least two semiconductor switches (14, 21; 15, 20; 16, 19; 17, 18) forming a half-bridge (12a; 12b; 12c; 12d) are connected in series;
- each semiconductor switch (14, 21; 15, 20; 16, 19; 17, 18) is provided with a control input (G) which is connected to a driving means (23, 24);
- each first semiconductor switch (14; 15; 16; 17) is at a high voltage potential (V_{SS}) with its source terminal (S);
- each second semiconductor switch (18; 19; 20; 21) is at a low voltage potential (V_{DD}) with its drain terminal (D);
- the drain terminal (D) of each first semiconductor switch (14; 15; 16; 17) is connected with the source terminal (S) of each respective second semiconductor switch (18; 19; 20; 21) for providing an output terminal (A); and
- at least one capacitor assembly (30) is arranged between the high and the low voltage potential (V_{SS}, V_{DD});
characterized in that
- said driving means (23, 24) activates said semiconductor switches (14, 21; 15, 20; 16, 19; 17, 18) by means of a control signal with a switching frequency of more than 20 kHz;
- said capacitor assembly (30) is made up by at least one sheet capacitor (30a) on a printed circuit board (33) carrying semiconductor switches (14, 21; 15, 20; 16, 19; 17, 18) and/or by at least one wrap capacitor (30b) designed as hollow coil (40);
- said semiconductor switches (14, 21; 15, 20; 16, 19; 17, 18) being arranged within said wrap capacitor (30b) designed as hollow coil (40); and
- a fluid cooling being provided within the hollow coil (40).

2. A half-bridge arrangement in accordance with claim 1, characterized in that hollow coil (40) is sealed in a fluid tight manner.

3. A half-bridge arrangement in accordance with claim 1, characterized in that said semiconductor switches (14, 21; 15, 20; 16, 19; 17, 18) are formed by high speed, low-loss field-effect transistors (FET's) or by high speed, low-loss bipolar transistors with insulated gate terminal (IGBT'S).

4. A half-bridge arrangement in accordance with one or several of the preceding claims, characterized in that several pairs of said series-connected semiconductor switches (14, 21; 15, 20; 16, 19; 17, 18) are connected in parallel.

5. A half-bridge arrangement in accordance with one or several of the preceding claims, characterized in that said semiconductor switches (14, 21; 15, 20; 16, 19; 17, 18) are constructed of a large number of individual semiconductor switching elements each of which having a small switching capacity.

6. A half-bridge arrangement in accordance with one or several of the preceding claims, characterized in that each driving means (23, 24) is arranged inside said hollow coil (40).

7. A half-bridge arrangement in accordance with one or several of the preceding claims, characterized in that
- the printed circuit board (33) is formed as a multilayer board with at least
- a first conductive layer (34) carrying the high voltage potential;
- a second conductive layer (35) carrying the low voltage potential; and
- an insulating layer (36) being arranged between the first and the second conductive layer (34, 35).

8. A half-bridge arrangement in accordance with one or several of the preceding claims, characterized in that
- said hollow coil (40) is formed of several layers with at least a first conductive layer (34) carrying the high voltage potential;
- at least a second conductive layer (34) carrying the low voltage potential; and
- an insulating layer (36) being arranged between the first and the second conductive layer (34, 35).

9. A half-bridge arrangement in accordance with one or several of the preceding claims, characterized in that
- said hollow coil (40) features several assemblies comprising first and second layers (34, 35; 34', 35') as well as insulating layers (36, 36'), wherein
- the individual assemblies extend at the inner side of said hollow coil (40) in a circumferential direction in an offset manner so that areas (34a, 35a; 34'a, 35'a) of the individual first and second conductive layers (34, 35; 34', 35') as well as
- insulated conductor strips (45) are exposed.

10. A half-bridge arrangement in accordance with one or several of the preceding claims, characterized in that
- the individual assemblies comprising the first and second layers (34, 35; 34', 35') as well as the insulating layers (36, 36') are sandwiched in such a manner that each of the first or second conductive layer (35), respectively, of an assembly is arranged adjacent to the first or second conductive layer (35'), respectively, of another assembly, and
- a thin insulating layer (39) is arranged between the individual assemblies.

11. A half-bridge arrangement in accordance with one or several of the preceding claims, characterized in that
- said first conductive layer (34; 34') is a copper layer with a thickness of at least 70 µm;
- said second conductive layer (35; 35') is a copper layer with a thickness of at least 70 µm; and
- said insulating layer (36; 36') is a plastic layer with a thickness of at least 10 - 20 µm made from Kapton.

12. A half-bridge arrangement in accordance with one or several of the preceding claims, characterized in that
- several printed circuit boards (33) with half-bridges (12, 12') are arranged in an axially spaced relationship in the interior of hollow coil (40),
- where terminals of the individual printed circuit boards for the high and low voltage potential or for the relevant capacitor assembly (30) or for control terminals and output terminals (A) are arranged at the circumference of the individual printed circuit boards (33) in such a manner that they make contact with exposed areas (34a, 35a; 34'a, 35'a) of said individual first and second conductive layers (34, 35; 34', 35') or said insulated conductor strips (45).

13. A half-bridge arrangement in accordance with one or several of the preceding claims, characterized in that said hollow coil (40) is provided with a shroud (52) so that the entire arrangement is made resistant to pressure of up to approximately 15 bar.

14. A half-bridge arrangement in accordance with one or several of the preceding claims, characterized in that
- fluid cooling is effected as boiling bath cooling with a liquid fluorocarbon with the pressure in the interior of hollow coil (40) ranging from 50 mbar to 3 bar, and with
- the temperature difference between semiconductor switches (14, 21; 15, 20; 16, 19; 17, 18) and the environment surrounding hollow coil (40) amounting to approx. 10°C.

15. A half-bridge arrangement in accordance with one or several of the preceding claims, characterized in that
- said boiling bath cooling includes a down cooling heat exchanger which via
- convection cooling means (50) arranged at the outer surface of said hollow coil (40) removes dissipitated heat from the interior of said hollow coil (40).

## Revendications

1. Dispositif en demi-pont pour la commutation de puissances électriques, dans lequel
- au moins deux interrupteurs à semi-conducteurs (14, 21; 15, 20; 16, 19; 17, 18) sont branchés en série en constituant un demi-pont (12a; 12b; 12c; 12d);
- chaque interrupteur à semi-conducteur (14, 21; 15, 20; 16, 19; 17, 18) présente une entrée de commande (6) reliée à un dispositif d'attaque (23, 34);
- chaque premier interrupteur à semi-conducteur (14; 15; 16; 17) est placé à un potentiel de tension (V_{SS}) élevé par son raccordement de source (S);
- chaque deuxième interrupteur à semi-conducteur (18; 19; 20; 21) est placé à un potentiel de tension (V_{DD}) bas par son raccordement de drain (D);
- pour constituer un raccordement de sortie (A), le raccordement de drain (D) de chaque premier interrupteur à semi-conducteur (14; 15; 16; 17) est relié au raccordement de source (S) appartenant chaque fois au deuxième interrupteur à semi-conducteur (18; 19; 20; 21); et
- au moins un dispositif à condensateur (30) est disposé entre le potentiel de tension élevé et le potentiel de tension bas (V_{SS}, V_{DD});
- le dispositif d'attaque (23, 24) attaque l'interrupteur à semi-conducteur (14, 21; 15, 20; 16, 19; 17, 18) avec un signal de commande d'une fréquence de commutation supérieure à 20 kHz; caractérisé en ce que
- le dispositif à condensateur (30) est constitué par au moins un condensateur de surface (30a) placé sur une platine (33) portant les interrupteurs à semi-conducteur (14, 21; 15, 20; 16, 19; 17, 18) et/ou par au moins un condensateur à enroulement (30b) formé sous forme d'enroulement creux (40);
- les interrupteurs à semi-conducteurs (14, 21; 15, 20; 16, 19; 17, 18) sont disposés dans le condensateur à enroulement (30b) constitué en enroulement creux (40); et
- un refroidissement par fluide est prévu dans l'enroulement creux (40).

2. Dispositif en demi-pont selon la revendication 1, caractérisé en ce que l'enroulement creux (40) est obturé de façon étanche au fluide.

3. Dispositif en demi-pont selon la revendication 1, caractérisé en ce que les interrupteurs à semi-conducteurs (14, 21; 15, 20; 16, 19; 17, 18) sont constitués par des transistors à effet de champ (FET) à faible perte, à commutation rapide ou bien par des transistors bipolaires à faible perte à commutation rapide, à raccordement de grille (IGBT) isolé.

4. Dispositif en demi-pont selon l'une ou plusieurs des revendications précédentes, caractérisé en ce que plusieurs paires d'interrupteurs à semi-conducteurs (14, 21; 15, 20; 16, 19; 17, 18) branchés en série sont branchés en parallèle.

5. Dispositif en demi-pont selon l'une ou plusieurs des revendications précédentes, caractérisé en ce que les interrupteurs à semi-conducteurs (14, 21; 15, 20; 16, 19; 17, 18) sont constitués par un grand nombre de composants individuels à semi-conducteurs ayant chacun de petites puissances de commutation.

6. Dispositif en demi-pont selon l'une ou plusieurs des revendications précédentes, caractérisé en ce que chaque dispositif d'attaque (23, 24) est disposé à l'intérieur de l'enroulement creux (40).

7. Dispositif en demi-pont selon l'une ou plusieurs des revendications précédentes, caractérisé en ce que
- la platine (33) est réalisée sous forme de platine multicouche,
au moins
- une première couche conductrice (34) servant au passage du potentiel de tension élevé;
- une deuxième couche conductrice (35) servant au passage du potentiel de tension faible; et
- une couche isolante (36) étant disposée entre la première et la deuxième couche conductrice (34, 35).

8. Dispositif en demi-pont selon l'une ou plusieurs des revendications précédentes, caractérisé en ce que
- l'enroulement creux (40) est réalisé en multicouche, au moins une première couche conductrice (34) servant au passage du potentiel de tension élevé;
- au moins une deuxième couche conductrice (35) sert au passage du potentiel de tension bas; et
- entre la première et la deuxième couche conductrice (34, 35) est disposée une couche isolante (36).

9. Dispositif en demi-pont selon l'une ou plusieurs des revendications précédentes, caractérisé en ce que
- l'enroulement creux (40) présente plusieurs dispositifs constitués de premières et deuxièmes couches (34, 35; 34', 35') ainsi que de couches isolantes (36, 36'), où
- les différents dispositifs partent en face intérieure de l'enroulement creux (40), décalés dans la direction périphérique, de manière que des zones (34a, 35a, 34'a, 35'a) des premières et deuxièmes couches conductrices (34, 35; 34', 35') individuelles soient dégagées ainsi que
- des bandes conductrices (45) isolées.

10. Dispositif en demi-pont selon l'une ou plusieurs des revendications précédentes, caractérisé en ce que
- les différents dispositifs constitués de premières et deuxièmes couches (34, 35; 34', 35'), ainsi que de la couche isolante (36, 36'), sont disposés en couches les uns au dessus des autres de manière que chaque première ou deuxième couche conductrice (35) d'un dispositif soit voisine de la première ou deuxième couche conductrice (35') de l'un des autres dispositifs, et
- une couche isolante (39) mince est disposée entre les différents dispositifs.

11. Dispositif en demi-pont selon l'une ou plusieurs des revendications précédentes, caractérisé en ce que
- la première couche conductrice (34, 34') est une couche de cuivre ayant une épaisseur d'au moins 70 µm;
- la deuxième couche conductrice (35, 35') est une couche de cuivre ayant une épaisseur d'au moins 70 µm; et
- la couche isolante (36; 36') est une couche en matière synthétique ayant une épaisseur d'au moins 10 à 20 µm et réalisée en Kapton.

12. Dispositif en demi-pont selon l'une ou plusieurs des revendications précédentes, caractérisé en ce que
- à l'intérieur de l'enroulement creux (40) sont disposées avec espacement axial plusieurs platines (33) avec des demi-ponts (12; 12'),
- les raccordements des différentes platines destinées au potentiel de tension élevé et au potentiel de tension bas ou au dispositif à condensateur (30) respectif ou pour les raccordements de commande et les raccordements de sortie (A) sont disposés à la périphérie des différentes platines (33) de manière qu'ils mettent en contact les zones (34a, 35a; 34'a, 35'a) libres des différentes premières et deuxièmes couches conductrices (34, 35; 34', 35'), respectivement bandes conductrices isolées (45).

13. Dispositif en demi-pont selon l'une ou plusieurs des revendications précédentes, caractérisé en ce que l'enroulement creux (40) présente un enrobage (52), de sorte que l'ensemble du dispositif est résistant à une pression allant jusqu'à environ 15 bar.

14. Dispositif en demi-pont selon l'une ou plusieurs des revendications précédentes, caractérisé en ce que
- le refroidissement par fluide est réalisé sous forme de refroidissement par bain à ébullition avec un hydrocarbure fluoré liquide, la pression à l'intérieur de l'enroulement creux (40) étant comprise entre 50 mbar et 3 bar, et
- la différence de température entre les interrupteurs à semi-conducteurs (14, 21; 15, 20; 16, 19; 17, 18) et l'atmosphère entourant l'enroulement creux (40) étant d'à peu près 10 °C.

15. Dispositif en demi-pont selon l'une ou plusieurs des revendications précédentes, caractérisé en ce que
- le refroidissement à bain à ébullition présente un échangeur de refroidissement, qui
- sur les dispositifs de refroidissement à convection (50) disposés sur la surface extérieure de l'enroulement creux (40) évacue la chaleur de perte venant de l'intérieur de l'enroulement creux (40).
